# FASCICULE DE BREVET EUROPEEN

(11) **EP 3 811 418 B1**
(45) Date de publication et mention de la délivrance du brevet: **02.08.2023**
(21) Numéro de dépôt: 19745694.0
(22) Date de dépôt: 19.06.2019
(51) Int. Cl.: H01L 33/08, H01L 33/10, H01L 33/18

(54) **DISPOSITIF OPTOELECTRONIQUE COMPRENANT UNE MATRICE DE DIODES**
OPTOELEKTRONISCHE VORRICHTUNG MIT EINER DIODENMATRIX
OPTOELECTRONIC DEVICE COMPRISING A DIODE ARRAY

(30) Priorité: 20.06.2018 FR 1855450
(43) Date de publication de la demande: 28.04.2021
(60) Demande divisionnaire: 23174983.9
(73) Titulaire: Aledia, 38130 Echirolles (FR)
(72) Inventeur: DUPONT, Tiphaine, 38000 GRENOBLE (FR); ROBIN, Ivan-Christophe, 38000 GRENOBLE (FR)
(74) Mandataire: Cabinet Beaumont
(86) Numéro de dépôt international: PCT/FR2019/051507
(87) Numéro de publication internationale: WO 2019/243746

(56) Documents cités:
- EP-A1- 1 804 350
- EP-A2- 2 665 100
- US-A1- 2008 218 740
- US-A1- 2009 032 800
- US-A1- 2016 190 392
- CALLEJA E ET AL: "Growth, morphology, and structural properties of group-III-nitride nanocolumns and nanodisks", PHYSICA STATUS SOLIDI. B, BASIC RESEA, AKADEMIE VERLAG, BERLIN, DE, vol. 244, no. 8, 1 août 2007 (2007-08-01), pages 2816-2837, XP009109941, ISSN: 0370-1972, DOI: 10.1002/PSSB.200675628

## Description

La présente demande de brevet revendique la priorité de la demande de brevet français FR18/55450

### Domaine

La présente demande concerne un dispositif optoélectronique, notamment un écran d'affichage ou un dispositif de projection d'images, comprenant des diodes électroluminescentes à base de matériaux semiconducteurs, et leurs procédés de fabrication.

### Exposé de l'art antérieur

Il est connu de projeter des images sur des entrées de réseaux de guides d'onde d'écrans transparents, par exemple des lunettes, des parebrises de voitures ou des vitres, les images étant ensuite projetées vers l'oeil de l'utilisateur. Cela est par exemple le cas pour des lunettes intelligentes ou des lunettes de réalité augmentée. Pour ce faire, des dispositifs optoélectroniques projettent des images sur l'écran. Les images sont alors guidées dans l'écran jusqu'à atteindre un système permettant aux images d'être vues par un utilisateur. Ces dispositifs optoélectroniques peuvent comprendre des diodes électroluminescentes par exemple à base de matériaux semiconducteurs. Les écrans sont généralement configurés pour guider convenablement seulement le rayonnement émis par les diodes électroluminescentes qui se propage sensiblement dans une direction donnée. La directivité du rayonnement fourni par les diodes électroluminescentes est donc une caractéristique importante de tels dispositifs optoélectroniques.

US 2009/032800 A1 divulgue un dispositif optoélectronique comprenant une matrice de diodes axiales,chaque diode électroluminescente comprenant une zone active (14), la matrice formant un cristal photonique configuré pour maximiser l'intensité du rayonnement électromagnétique fourni par la matrice de diodes, dans lequel la matrice comprend un support (11) sur lequel reposent les diodes, chaque diode comprenant un empilement d'une première région semiconductrice (13) reposant sur le support, de la zone active (14) en contact avec la première région semiconductrice et d'une deuxième région semiconductrice (15) en contact avec la zone active, les secondes régions des diodes étant recouvertes d'une couche (16) conductrice et au moins en partie transparente aux rayonnements émis par les diodes.

EP 1 804 350 A1 divulgue un dispositif optoélectronique, en particulier un laser, comprenant une matrice de diodes axiales (6), chaque diode comprenant une zone active (2), la matrice formant un cristal photonique configuré pour maximiser l'intensité du rayonnement électromagnétique fourni par la matrice de diodes, dans lequel la matrice comprend un support (non représenté) sur lequel reposent les diodes, chaque diode comprenant un empilement d'une première région semiconductrice (1) reposant sur le support, de la zone active (2) en contact avec la première région semiconductrice et d'une deuxième région semiconductrice (3) en contact avec la zone active, le dispositif comprenant une couche réfléchissante (4) entre le support et les premières régions des diodes, les secondes régions des diodes étant recouvertes d'une couche (5) conductrice.

CALLEJA E ET AL: "Growth, morphology, and structural properties of group-III-nitride nanocolumns and nanodisks",PHYS. STAT. SOL. (b) 244, No.8, 2816-2837 (2007)est une revue des connaissances de l'art antérieur, illustrant notamment des diodes axiales filaires, formées de façon à présenter une cavité telle que la région active se situe à un extrémum de l'onde stationnaire, en vue d'augmenter l'intensité énergétique du rayonnement émis.

### Résumé

Ainsi, un mode de réalisation selon l'invention prévoit un dispositif optoélectronique comprenant une matrice de diodes axiales, chaque diode formant une cavité résonnante dans laquelle se forme une onde électromagnétique stationnaire, chaque diode électroluminescente comprenant une zone active située sensiblement au niveau d'un extrémum de l'onde électromagnétique, la matrice formant un cristal photonique configuré pour maximiser l'intensité du rayonnement électromagnétique fourni par la matrice de diodes.

La matrice comprend un support sur lequel reposent les diodes, chaque diode comprenant un empilement d'une première région semiconductrice reposant sur le support, de la zone active en contact avec la première région semiconductrice et d'une deuxième région semiconductrice en contact avec la zone active.

Le dispositif comprend une couche réfléchissante entre le support et les premières régions des diodes.

Selon un mode de réalisation, la couche réfléchissante est en métal.

Selon invention, les secondes régions des diodes sont recouvertes d'une couche conductrice et au moins en partie transparente aux rayonnements émis par les diodes.

Selon un mode de réalisation, la hauteur d'au moins une des diodes est sensiblement proportionnelle à kλ/2n, où λ est la longueur d'onde du rayonnement émis par la diode, k est un entier positif et n est sensiblement égal à l'indice de réfraction effectif de la diode dans le mode optique considéré.

Selon un mode de réalisation, les diodes sont séparées par un matériau isolant électriquement.

Selon un mode de réalisation, la matrice comprend au moins des premier et deuxième ensembles de diodes, les diodes du premier ensemble ayant une même première hauteur, les diodes du deuxième ensemble ayant une même deuxième hauteur, les première et deuxième hauteurs étant différentes.

Selon un mode de réalisation, pour au moins l'une des diodes, la première région de la diode comprend au moins deux parties séparées par une couche d'arrêt de gravure.

Selon un mode de réalisation, chaque couche d'arrêt de gravure a une épaisseur comprise entre 1 et 200 nm.

Selon un mode de réalisation, le quotient du pas de la matrice sur la longueur d'onde du rayonnement électromagnétique fourni est compris entre environ 0,4 et environ 0,92.

Selon un mode de réalisation, les diodes sont des diodes électroluminescentes ou des photodiodes.

Un autre mode de réalisation selon l'invention prévoit un procédé de fabrication d'un dispositif optoélectronique comprenant une matrice de diodes axiales, chaque diode formant une cavité résonnante dans laquelle se forme une onde électromagnétique stationnaire, la zone active de chaque diode étant située sensiblement au niveau d'un extrémum de l'onde électromagnétique, le pas de la matrice étant configuré pour maximiser l'intensité fournie par la matrice de diodes.

La formation des diodes de la matrice comprend :
la formation de premières régions sur un substrat, les premières régions étant séparées les unes des autres par le pas de la matrice ;
la formation d'un zone active sur chaque première région ; et
la formation d'une seconde région sur chaque zone active.

Selon un mode de réalisation, le procédé comprend une première étape de gravure de l'ensemble des deuxièmes régions de manière à ce qu'elles aient une même hauteur.

Selon un mode de réalisation, le procédé comprend une deuxième étape de gravure de l'ensemble des premières régions de manière à ce qu'elles aient la hauteur permettant à la zone active d'être située au niveau d'un extremum de l'onde électromagnétique.

Selon un mode de réalisation, la deuxième étape de gravure est effectuée avant la formation des zones actives.

Selon un mode de réalisation, la deuxième étape de gravure est précédée d'une étape de retrait du substrat, la deuxième étape de gravure étant réalisée par l'extrémité de la diode qui était la plus proche du substrat.

Selon l'invention, le procédé comprend la formation d'au moins une couche dans la première région d'au moins l'une des diodes adaptée à servir de couche d'arrêt de la deuxième étape de gravure.

Selon un mode de réalisation, les diodes sont des diodes électroluminescentes ou des photodiodes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective, partielle et schématique, d'un mode de réalisation d'une diode électroluminescente axiale ;
la figure 2 est une vue en perspective, partielle et schématique, d'un mode de réalisation d'une matrice de diodes électroluminescentes ;
les figures 3A et 3B représentent schématiquement des exemples d'agencements des diodes électroluminescentes de la matrice de la figure 2 ;
les figures 4A à 4F sont des vues en coupe, partielles et schématiques, illustrant les structures obtenues à des étapes d'un exemple comparatif, ne faisant pas partie de l'invention, d'un procédé de fabrication de la matrice de la figure 2 ;
les figures 5A à 5D sont des vues en coupe, partielles et schématiques, illustrant les structures obtenues à d'autres étapes d'un exemple comparatif, ne faisant pas partie de l'invention, de procédé de fabrication de la matrice de la figure 2 ;
la figure 6 est une vue en coupe, partielle et schématique, illustrant la structure obtenue à une étape d'un mode de réalisation d'un procédé de fabrication de la matrice de la figure 2 ;
les figures 7A et 7B sont des vues en coupe, partielles et schématiques, illustrant les structures obtenues à des étapes d'un mode de réalisation d'un procédé de fabrication de la matrice de la figure 2 ;
la figure 8 est un graphique représentant l'intensité émise par une matrice telle que celle de la figure 2 en fonction de certaines caractéristiques de la matrice ;
les figures 9A à 9E sont des graphiques illustrant des résultats de simulations pour des modes de réalisation de matrices de diodes électroluminescentes ; et
les figures 10A à 10E sont des graphiques illustrant des résultats de simulations pour d'autres modes de réalisation de matrices de diodes électroluminescentes.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les dispositifs optoélectroniques considérés comprennent éventuellement d'autres composants qui ne seront pas détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des éléments concernés dans les figures. Sauf précision contraire, les expressions "approximativement", "environ", "sensiblement", et "de l'ordre de" signifient à 10 % près, de préférence à 5 % près.

Lorsque l'on parle d'éléments (couches, matériaux, etc.) "transparents" ou "réfléchissants", on considère des éléments transparents ou réfléchissants aux longueurs d'onde auxquelles le dispositif est destiné à fonctionner, par exemple les longueurs d'onde des rayonnements électromagnétiques émis par les diodes électroluminescentes considérées.

En outre, on appelle "zone active" d'une diode électroluminescente la région de la diode électroluminescente depuis laquelle est émise la majorité du rayonnement électromagnétique fourni par la diode électroluminescente.

Par diode électroluminescente axiale, on désigne une structure tridimensionnelle de forme allongée, par exemple cylindrique, selon une direction privilégiée dont au moins deux dimensions, appelées dimensions mineures, sont comprises entre 5 nm et 2,5 µm, de préférence entre 50 nm et 2,5 µm. La troisième dimension, appelée dimension majeure, est supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 800 nm. Dans certains modes de réalisation, la hauteur de chaque diode électroluminescente peut être supérieure ou égale à 500 nm, de préférence comprise entre 1 µm et 50 µm.

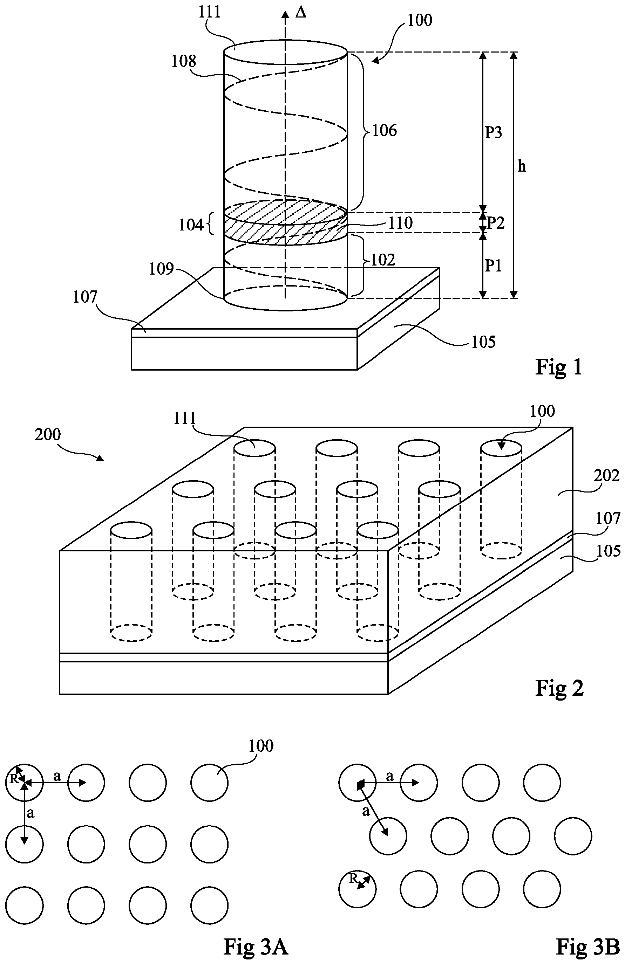

La figure 1 est une vue en perspective d'un mode de réalisation d'une diode électroluminescente axiale 100.

La diode électroluminescente 100 comprend un empilement d'une région 102, d'une zone active 104 et d'une région 106. La face supérieure de la région 102 est en contact avec la face inférieure de la zone active 104. La face supérieure de la zone active 104 est en contact avec la face inférieure de la région 106.

La diode électroluminescente 100 est dite axiale dans la mesure où la zone active 104 est dans le prolongement de la région 102 et la région 106 est dans le prolongement de la zone active 104. Un axe Δ correspond à l'axe de la diode électroluminescente axiale.

La région 102 est en un matériau semiconducteur dopé d'un premier type de conductivité, par exemple dopé P. La région 102 repose sur un support 105, par exemple un circuit électronique, par exemple un interposeur, comprenant des interconnexions prenant contact avec la région 102 et permettant de commander la diode électroluminescente 100. L'axe Δ est alors orthogonal à la face supérieure du support 105. La face inférieure 109 de la région 102, c'est-à-dire la face du côté du support 105, est en contact avec une couche réfléchissante. Par exemple, la face inférieure 109 peut être séparée du support 105 par une couche 107 de métal, par exemple de l'aluminium. Par exemple, la couche 107 de métal peut recouvrir entièrement ou partiellement le support 105.

La région 106 est en un matériau semiconducteur d'un second type de conductivité, par exemple de type N, différent du premier type de conductivité. La face supérieure 111 de la région 106 est recouverte d'une couche (ou d'un empilement de couches) d'un ou plusieurs matériaux transparents ou semiréfléchissants, non représenté, par exemple une couche d'oxyde transparent conducteur (TCO).

Les régions 102 et 106 peuvent être, au moins en partie, formées à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore (P) ou l'arsenic (As). De façon générale, les éléments dans le composé III-V peuvent être combinés avec différentes fractions molaires.

Les régions 102 et 106 peuvent être, au moins en partie, formées à partir de matériaux semiconducteurs comportant majoritairement un composé II-VI. Des exemples d'éléments du groupe II comprennent des éléments du groupe IIA, notamment le béryllium (Be) et le magnésium (Mg), et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les régions 102 et 106 peuvent être, au moins en partie, formées à partir de matériaux semiconducteurs comportant majoritairement au moins un élément du groupe IV. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC).

Les régions 102 et 106 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

De préférence, la région 102 est une région en GaN dopé P et la région 106 est une région en GaN dopé N.

Pour chaque diode électroluminescente, la zone active 104 peut comporter des moyens de confinement. A titre d'exemple, la zone 104 peut comprendre un puits quantique unique. Elle comprend alors un matériau semiconducteur différent du matériau semiconducteur formant les régions 102 et 106 et ayant une bande interdite inférieure à celle du matériau formant les régions 102 et 106. La zone active 104 peut comprendre des puits quantiques multiples. Elle comprend alors un empilement de couches semiconductrices formant une alternance de puits quantiques et de couches barrières.

En figure 1, la diode électroluminescente 100 représentée a la forme d'un cylindre à base circulaire d'axe Δ. Toutefois, la diode électroluminescente 100 peut avoir la forme d'un cylindre d'axe Δ à base polygonale, par exemple carrée, rectangulaire ou hexagonale. De préférence, la diode électroluminescente 100 a la forme d'un cylindre à base hexagonale.

La hauteur h de la diode électroluminescente 100, c'est-à-dire la distance entre la face inférieure 109 de la région 102 et la face supérieure 111 de la région 106, est sensiblement proportionnelle à k*λ/2*neff, λ étant la longueur d'onde du rayonnement émis par la diode électroluminescente, neff étant l'indice de réfraction effectif de la diode électroluminescente dans le mode optique considéré et k étant un entier positif. L'indice de réfraction effectif est par exemple défini dans l'ouvrage "Semiconductor Optoelectronic Devices : Introduction to Physics and Simulation" de Joachim Piprek.

La hauteur h est égale à la somme de la hauteur P1 de la région 102, de la hauteur P2 de la zone active 104, de la hauteur P3 de la région 106 et de la hauteur des couches éventuelles qui peuvent recouvrir la face 111.

La diode électroluminescente 100 forme une cavité résonnante selon l'axe Δ. Ainsi, une onde électromagnétique stationnaire selon l'axe Δ se forme dans la diode électroluminescente en fonctionnement, ce qui est illustré très schématiquement en figure 1 par une courbe 108. L'onde suit les axes de symétrie de la diode électroluminescente 100. Ainsi, l'onde a par exemple une symétrie de révolution si la diode électroluminescente a une section circulaire. Par une onde électromagnétique stationnaire selon l'axe Δ, on entend une onde électromagnétique dont les noeuds, c'est à dire les points d'intensité nulle, sont fixes dans l'espace et dont l'intensité en les autres points peut être variable dans le temps.

Selon l'invention, la zone active 104 est située, de façon avantageuse, au niveau d'un extrémum 110 de l'onde électromagnétique. L'intensité énergétique du rayonnement émis par la diode électroluminescente est alors plus importante et le rayonnement qui s'échappe de la diode électroluminescente est plus intense que dans le cas d'une diode électroluminescente de même structure dont la zone active ne serait pas située à un extremum de l'onde électromagnétique.

La figure 2 est une vue en perspective d'un mode de réalisation d'une matrice 200 de diodes électroluminescentes 100.

La matrice 200 comprend des diodes électroluminescentes 100 situées dans une couche 202 d'un matériau de remplissage, par exemple un matériau isolant électriquement, par exemple de l'oxyde de silicium. Dans le mode de réalisation de la figure 2, toutes les diodes électroluminescentes 100 ont la même hauteur. L'épaisseur de la couche 202 est par exemple choisie égale à la hauteur des diodes électroluminescentes de telle manière que la face supérieure de la couche 202 est coplanaire avec la face supérieure de chaque diode électroluminescente, c'est-à-dire avec la face supérieure 111 de chaque région 106.

Une couche d'électrode, non représentée, est au contact des faces supérieures des diodes électroluminescentes. Il s'agit d'une couche conductrice recouvrant la couche 202. La couche d'électrode est une couche transparente
La face supérieure de la matrice correspond à la face de la couche d'électrode opposée aux diodes électroluminescentes.

Douze diodes électroluminescentes 100 sont représentées en figure 2. En pratique, la matrice 200 peut par exemple comprendre entre 7 et 100000 diodes électroluminescentes.

Les diodes électroluminescentes 100 de la matrice 200 sont agencées en lignes et en colonnes (3 lignes et 4 colonnes étant représentées à titre d'exemple en figure 2). Le pas de la matrice est la distance entre l'axe d'une diode électroluminescente 100 et l'axe d'une diode électroluminescente 100 proche, de la même ligne ou d'une ligne adjacente. Le pas a est sensiblement constant. Plus précisément, le pas de la matrice est choisi de telle manière que la matrice 200 forme un cristal photonique. Le cristal photonique formé est par exemple un cristal photonique 2D.

Les propriétés du cristal photonique formé par la matrice 200 sont choisies avantageusement pour que l'intensité du rayonnement émis par l'ensemble des diodes électroluminescentes 100 de la matrice soit plus importante et que le rayonnement soit plus directif que dans le cas d'un ensemble de diodes électroluminescentes 100 qui ne formerait pas un cristal photonique.

Dans l'exemple de la figure 2, l'indice neff est sensiblement égal à la moyenne des indices de réfraction du GaN des diodes électroluminescentes 100 et du matériau de la couche 202, pondérées par le rapport FF d'aire entre les deux matériaux. L'indice neff est donc par exemple sensiblement égal à : FF * nGaN + (1 - FF) * nSiO2, où nGaN est l'indice de réfraction du GaN des diodes électroluminescentes 100, nSiO2 est l'indice de réfraction du matériau de la couche 202, et FF est égal à l'aire de la section horizontale d'une diode électroluminescente 100 sur l'aire de la section horizontale d'un élément périodique de la matrice 200. Par exemple, un élément périodique de la matrice 200 a une section horizontale carrée, centrée sur une diode électroluminescente 100 et de côté égal à la distance entre les axes Δ de deux diodes électroluminescentes voisines.

Les figures 3A et 3B représentent schématiquement des exemples d'agencements des diodes électroluminescentes 100 de la matrice 200. En particulier, la figure 3A illustre un agencement dit en maillage carré et la figure 3B illustre un agencement dit en maillage hexagonal.

Les figures 3A et 3B illustrent, de plus, le pas a de la matrice, c'est-à-dire la distance entre l'axe d'une diode électroluminescente et l'axe de la diode électroluminescente la plus proche de la même ligne ou d'une ligne adjacente. Les figures 3A et 3B illustrent aussi le rayon R d'une diode électroluminescente 100 dont la base est circulaire. Dans le cas où la diode électroluminescente n'est pas à base circulaire, le rayon R correspond au rayon du cercle dans lequel la base est inscrite.

La figure 3A représente trois lignes de quatre diodes électroluminescentes 100. Dans cet agencement, une diode électroluminescente 100 est située à chaque croissement d'une ligne et d'une colonne, les lignes étant perpendiculaires aux colonnes.

La figure 3B représente, comme la figure 3A, trois lignes de quatre diodes électroluminescentes 100. Dans cet agencement, les diodes sur une ligne sont décalées de la moitié du pas a par rapport aux diodes électroluminescentes sur la ligne précédente et la ligne suivante.

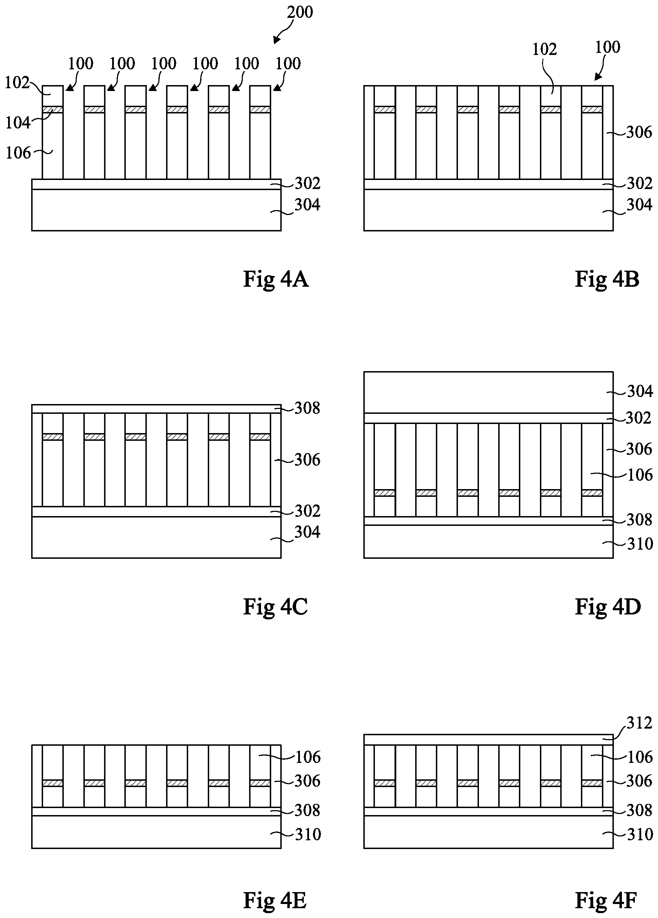

Les figures 4A à 4F sont des vues en coupe illustrant les structures obtenues à des étapes d'un exemple comparatif, ne faisant pas partie de l'invention, de procédé de fabrication de la matrice 200 de la figure 2.

La figure 4A illustre la structure obtenue après les étapes de formation décrites ci-après.

Une couche de germination 302 est formée sur un substrat 304. Des diodes électroluminescentes 100 sont ensuite formées à partir de la couche de germination 302. Plus précisément, les diodes électroluminescentes 100 sont formées de telle manière que les régions 106 soient en contact avec la couche de germination 302. La zone active 104 de chaque diode électroluminescente 100 est située sur la région 106 et la région 102 est située sur la zone active 104.

De plus, les diodes électroluminescentes 100 sont situées de manière à former la matrice 200, c'est-à-dire à former des lignes et des colonnes avec le pas souhaité de la matrice 200. Seule une ligne est représentée sur les figures 4A à 4F.

Un masque non représenté peut être formé avant la formation des diodes électroluminescentes sur la couche de germination 302 de manière à découvrir uniquement les parties de la couche de germination 302 aux emplacements où seront situées les diodes électroluminescentes. A titre de variante, la couche de germination peut être gravée de manière à former des plots situés aux emplacements où seront situées les diodes électroluminescentes.

Le procédé de croissance des diodes électroluminescentes 100 peut être un procédé du type dépôt chimique en phase vapeur (CVD, sigle anglais pour Chemical Vapor Déposition) ou dépôt chimique en phase vapeur aux organométalliques (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Déposition), les procédés hydrothermiques, la pyrolyse d'aérosol liquide ou l'électrodépôt.

Les conditions de croissance des diodes électroluminescentes 100 sont telles que toutes les diodes électroluminescentes de la matrice 200 se forment sensiblement à la même vitesse. Ainsi, les hauteurs des régions 102 et 106 et la hauteur de la zone active 104 sont sensiblement identiques pour toutes les diodes électroluminescentes de la matrice 200.

On considère, de plus, que les hauteurs de la région 102 et de la zone active 104 correspondent sensiblement aux valeurs P1 et P2 décrites précédemment et déterminées pour que, en fonctionnement, la zone active 104 soit située sur un extrémum de l'onde électromagnétique. La hauteur de la région 106 est supérieure à la valeur P3 voulue. Il peut être difficile de contrôler avec précision la hauteur de la région 106 notamment en raison du début de croissance de la région 106 depuis la couche de germination 302. De plus, la formation du semiconducteur directement sur la couche de germination peut causer des défauts cristallins dans le matériau semiconducteur juste au-dessus de la couche de germination. On peut donc vouloir retirer une partie de la région 106.

La figure 4B illustre la structure obtenue après la formation d'une couche 306 d'un matériau de remplissage correspondant au matériau de la couche 202, par exemple un matériau isolant électriquement, par exemple de l'oxyde de silicium. La couche 306 est par exemple formée en déposant une couche de matériau de remplissage sur la structure, la couche ayant une épaisseur supérieure à la hauteur des diodes électroluminescentes 100. La couche de matériau de remplissage est ensuite partiellement retirée de manière à être planarisée pour découvrir les faces supérieures des régions 102 correspondant chacune à la face 109 décrite en relation avec la figure 1. La face supérieure de la couche 306 est donc sensiblement coplanaire avec la face supérieure de chaque région 102. A titre de variante, le procédé peut comprendre une étape de gravure au cours de laquelle les régions 102 sont partiellement gravées.

Le matériau de remplissage est choisi de telle manière que le cristal photonique formé par la matrice 200 ait les propriétés voulues, c'est-à-dire qu'il améliore la directivité et l'intensité du rayonnement émis par les diodes électroluminescentes 100.

La figure 4C illustre la structure obtenue après le dépôt d'une couche 308 sur la structure obtenue à l'étape précédente. La couche 308 est une couche réfléchissante, par exemple une couche de métal, par exemple une couche d'aluminium. La couche 308 est aussi une couche conductrice électriquement connectant les unes aux autres toutes les régions 102 de la matrice 200. Les diodes électroluminescentes 100 de la matrice 200 pourront donc être commandées par l'intermédiaire de cette couche 308.

La figure 4D illustre la structure obtenue après la fixation à un support 310 de la face de la couche 308 qui n'est pas en contact avec la couche 306, par exemple par collage métal-métal, par thermocompression ou par brasure avec utilisation d'une eutectique du côté du support 310. Le support 310 est par exemple un circuit électronique, par exemple un interposeur, comprenant des interconnexions non représentées en contact avec la couche 308.

La figure 4E illustre la structure obtenue après le retrait du substrat 304 et de la couche de germination 302. De plus, la couche 306 et les régions 106 sont gravées de telle manière que la hauteur de chaque région 106 ait la valeur P3 permettant à la zone active d'être placée comme décrit précédemment. Cette étape permet, de façon avantageuse, de contrôler exactement la hauteur h des diodes électroluminescentes et de retirer les parties des régions 106 pouvant avoir des défauts cristallins.

La figure 4F illustre la structure obtenue après le dépôt d'une couche 312 sur la structure obtenue à l'étape précédente. La couche 312 est transparente ou semi-réfléchissante, de manière à permettre l'émission du rayonnement, et conductrice, de manière à commander les diodes électroluminescentes 100. La couche 312 est par exemple en oxyde transparent conducteur, par exemple en oxyde de zinc ou en oxyde d'indium et d'étain, ou peut être un empilement de couches d'oxydes de manière à pouvoir ajuster la réflectivité de l'empilement selon les épaisseurs et les indices de réfraction des matériaux de l'empilement.

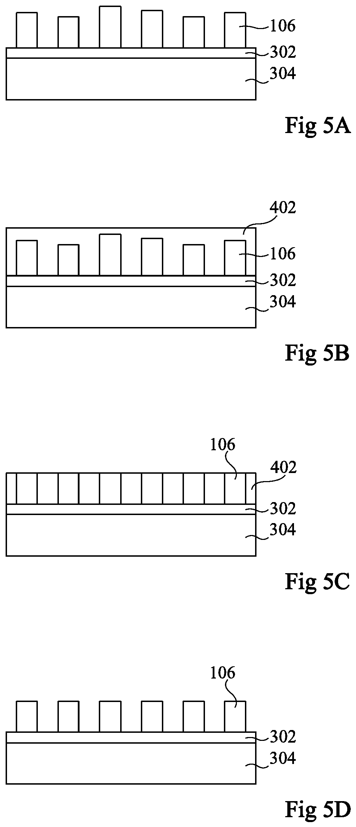

Les figures 5A à 5D sont des vues en coupe illustrant les structures obtenues à d'autres étapes d'un mode de réalisation de procédé de fabrication de la matrice 200 de la figure 2. Plus précisément, les figures 5A à 5D illustrent au moins partiellement la formation des régions 106.

La figure 5A illustre la structure obtenue après la formation des régions 106 sur la couche de germination 302 recouvrant le substrat 304.

Le présent mode de réalisation est par exemple adapté au cas où les conditions de croissance des diodes électroluminescentes 100 sont telles que des régions 106 ayant des hauteurs différentes sont obtenues.

La figure 5B illustre la structure après la formation d'une couche 402 de matériau de remplissage, par exemple de l'oxyde de silicium, sur les régions 106. La formation de la couche 402 comprend par exemple le dépôt d'une couche de matériau de remplissage dont l'épaisseur est supérieure à la hauteur des régions 106 situées sur la couche 302.

La figure 5C illustre la structure obtenue après la gravure des régions 106, et de la couche 402 de telle manière que les faces supérieures de toutes les régions 106 et la face supérieure de la couche 402 soient coplanaires. Les régions 106 ont alors toutes la même hauteur.

La figure 5D illustre la structure obtenue après le retrait de la couche 402.

La croissance des diodes électroluminescentes 100 peut ensuite reprendre, par exemple pour atteindre la structure décrite en relation avec la figure 4A. Les diodes électroluminescentes 100 ont alors une croissance sensiblement à la même vitesse. L'étape de la figure 5D est par exemple suivie d'une étape de croissance du reste de la région 106 et de la croissance de la zone active 104 et de la région 102. A titre de variante, l'étape de la figure 5D peut être suivie directement d'une étape de croissance de la zone active 104 et de la région 102. Dans ce cas, la hauteur de la région 106 en figure 5D correspond déjà à la hauteur de la région 106 de la figure 4A. Les régions 106 et 102 et la zone 104 ont donc sensiblement la même hauteur quelle que soit la diode électroluminescente de la matrice. Le procédé décrit en relation avec les figures 4A à 4F peut ensuite reprendre.

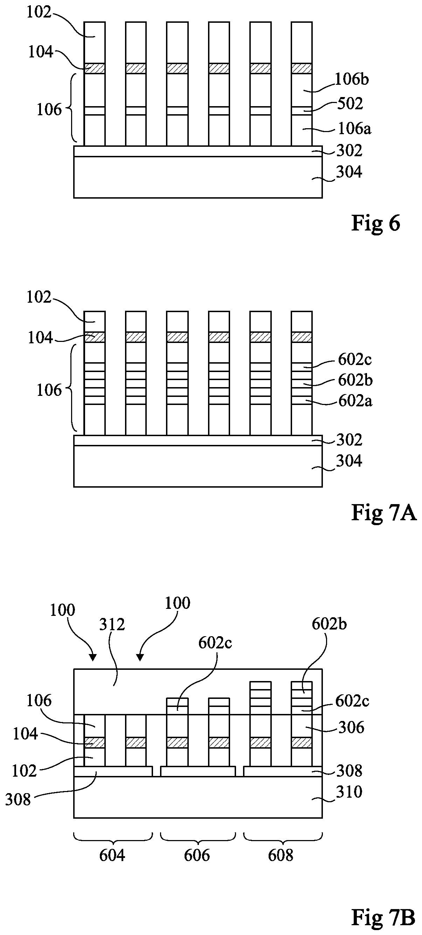

La figure 6 est une vue en coupe illustrant la structure obtenue à une étape d'un autre mode de réalisation de procédé de fabrication, selon l'invention, de la matrice de la figure 2. Cette étape suit par exemple l'étape illustrée en figure 5D.

Au cours de cette étape, une couche d'arrêt de gravure 502 est formée sur des parties 106a des régions 106 ayant été formées et planarisées précédemment, par exemple au cours du procédé décrit en relation avec les figures 5A à 5D. A titre d'exemple, le matériau composant la couche d'arrêt de gravure 502 peut être un nitrure, un carbure, un métal ou un borure d'un métal de transition de la colonne IV, V ou VI du tableau périodique des éléments ou une combinaison de ces composés. A titre d'exemple, la couche d'arrêt de gravure 502 peut être en nitrure d'aluminium (AlN), en oxyde d'aluminium (Al₂O₃), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), ou en nitrure de magnésium sous la forme MgₓN_{y}, où x est environ égal à 3 et y est environ égal à 2, par exemple du nitrure de magnésium selon la forme Mg₃N₂. La couche 502 a par exemple une épaisseur comprise entre environ 1 et 100 nm.

Des parties 106b des régions 106 sont ensuite formées sur les couches 502. Les zones actives 104 et les régions 102 sont ensuite formées sur les régions 106.

La hauteur de la partie 106b correspond sensiblement à la hauteur P3 voulue. La hauteur de la partie 106a est suffisamment grande pour inclure l'essentiel des défauts cristallins.

L'étape de la figure 6 peut ensuite être suivie par les étapes décrites en relation avec les figures 4B à 4F, la gravure de l'étape décrite précédemment en relation avec la figure 4E s'arrêtant sur la couche d'arrêt de gravure 502 et comprenant par exemple, le retrait de la couche d'arrêt de gravure 502.

Les figures 7A et 7B sont des vues en coupe illustrant les structures obtenues à des étapes d'un autre mode de réalisation de procédé de fabrication selon l'invention de la matrice de la figure 2. Plus précisément, les figures 7A et 7B illustrent la fabrication d'une matrice comprenant des diodes électroluminescentes ayant des hauteurs différentes.

La figure 7A illustre une étape équivalente à l'étape de la figure 4A correspondant à la croissance des diodes électroluminescentes 100, à la différence qu'au cours de cette étape, plusieurs couches d'arrêt de gravure sont formées dans chaque région 106. En figure 7A, trois couches d'arrêt de gravure 602a, 602b et 602c ont été formées dans chaque région 106, la couche 602a étant la plus proche de la couche de germination 302 et la couche 602c étant la plus proche de la zone active 104. Les couches d'arrêt de gravure sont par exemple en le même matériau et sont séparées les unes des autres par des parties des régions 106.

La figure 7B illustre la matrice de diodes électroluminescentes obtenue à partir de la structure de la figure 7A après des étapes similaires à celles décrites précédemment en relation avec les figures 4B, 4C et 4D.

Le procédé comprend ensuite des étapes de gravure. Au cours de ces étapes, pour un ensemble 604 de diodes électroluminescentes 100, la région 106 de chaque diode électroluminescente 100 est gravée depuis l'extrémité libre jusqu'à la couche d'arrêt de gravure 602c qui est également gravée. Pour un ensemble 606 de diodes électroluminescentes 100, la région 106 de chaque diode électroluminescente 100 est gravée depuis l'extrémité libre jusqu'à la couche d'arrêt de gravure 602b qui est ensuite gravée de manière à découvrir la partie de la région 106 située entre les couches d'arrêt de gravure 602b et 602c. Pour un ensemble 608 de diodes électroluminescentes 100, la région 106 de chaque diode électroluminescente 100 est gravée depuis l'extrémité libre jusqu'à la couche d'arrêt 602a qui est ensuite gravée de manière à découvrir la partie de la région 106 située entre les couches d'arrêt de gravure 602b et 602a.

Les diodes électroluminescentes des différents ensembles 604, 606 et 608 fournissent par exemple un rayonnement de même longueur d'onde λ et ont par exemple des hauteurs totales h égales à différents multiples de λ/2n. A titre de variante, les diodes électroluminescentes de différents ensembles 604, 606 et 608 peuvent être adaptées à émettre des rayonnements de longueurs d'onde différentes et ont donc des hauteurs différentes.

Le matériau et les dimensions des couches d'arrêt de gravure 602a, 602b, et 602c sont choisis de telle manière qu'ils aient un impact négligeable sur le fonctionnement des diodes électroluminescentes.

La couche 312 est ensuite déposée sur la structure. La couche 312 peut par exemple entourer une partie supérieure de la région 106 de certains ensembles de diodes électroluminescentes. L'épaisseur de la couche 312 est choisie de manière à recouvrir la face supérieure de chaque diode électroluminescente 100.

La couche 308 réfléchissante est divisée par exemple en plusieurs parties non connectées, chaque partie étant en contact avec un ensemble de diodes électroluminescentes. Ainsi, les différents ensembles de diodes électroluminescentes peuvent être commandés indépendamment les uns des autres.

De manière générale, le nombre de couches d'arrêt de gravure correspond au nombre de hauteurs de diodes électroluminescentes différentes souhaitées dans la matrice.

Un avantage des modes de réalisation de procédé de fabrication décrits précédemment est qu'ils permettent de positionner de manière précise la zone active 104 au sein de la diode électroluminescente 100, c'est-à-dire de contrôler les valeurs des hauteurs P1, P2 et P3.

Les figures suivantes 8, 9A à 9E et 10A à 10E illustrent les résultats de simulations concernant des exemples de matrices selon les modes de réalisation décrits précédemment. Ces simulations illustrent un procédé de détermination des dimensions des diodes électroluminescentes et du pas de la matrice. Pour les simulations, les diodes électroluminescentes de la matrice considérée comprennent des régions 102 et 106 en GaN. Les régions 102 ont une épaisseur supérieure ou égale à 30 nm. Les zones actives 104 comprennent une unique couche de InGaN, d'épaisseur égale à 40 nm. La couche 306 est en oxyde de silicium et la couche 308 de matériau réfléchissant est en aluminium. La couche 312 a une épaisseur de 50 nm. La couche 312 est en oxyde transparent conducteur d'indice de réfraction sensiblement égal à 2 à la longueur d'onde considérée, par exemple de l'ITO. Les diodes électroluminescentes 100 considérées ont une forme de cylindre à base circulaire. Les diodes électroluminescentes de la matrice ont un maillage carré. Chaque ligne et chaque colonne comprend sept diodes électroluminescentes. La matrice comprend donc ici quarante-neuf diodes électroluminescentes. On considère dans les simulations suivantes que toutes les diodes électroluminescentes ont la même hauteur.

On choisit d'imposer les contraintes suivantes en regard du taux de remplissage pour un maillage carré : 5 % ≤ πR²/a² ≤ 65 %, où R est le rayon de la section droite de chaque diode électroluminescente et a est le pas de la matrice.

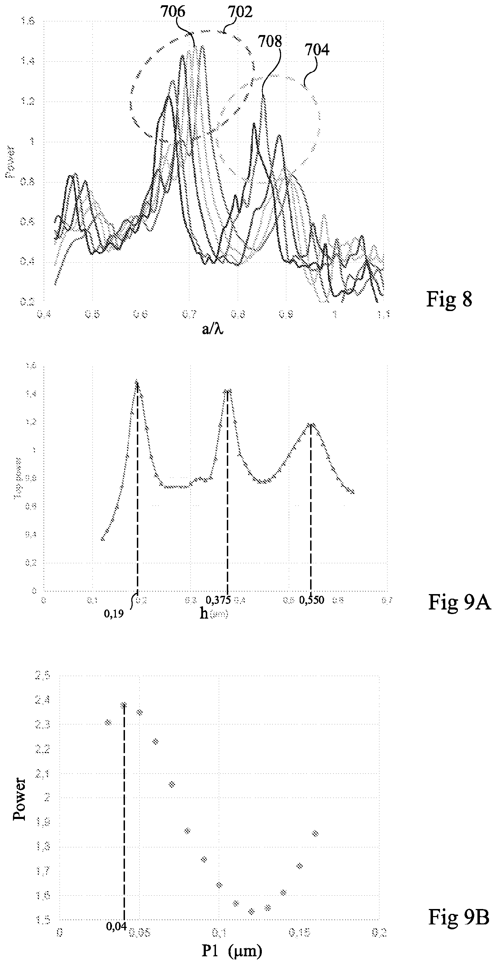

La figure 8 est un graphique comprenant des courbes d'évolution de l'intensité (Power) du rayonnement émis par la matrice en fonction d'un premier quotient a/λ où λ est la longueur d'onde du rayonnement émis par la matrice, chaque exemple de matrice, et donc chaque courbe, correspondant à une valeur différente d'un deuxième quotient 2πR/λ.

Pour des raisons de clarté, seules six courbes ont été représentées en figure 8. En pratique, des simulations ont été effectuées en faisant varier le deuxième quotient 2πR/λ de 0,7 à 1,7.

Cette figure permet de déterminer une ou plusieurs gammes de valeurs du premier quotient a/λ pour lesquelles apparaissent des pics d'intensité. Il est possible d'observer deux zones 702 et 704, chacune correspondant à une telle gamme de valeurs. Chacune des courbes comprend un pic dans au moins l'une des deux zones 702 et 704.

La zone 702 correspond à une gamme de valeurs du premier quotient a/λ sensiblement comprises entre environ 0,4 et environ 0,82. La zone 704 correspond à une gamme de valeurs du premier quotient a/λ sensiblement comprises entre environ 0,8 et environ 0, 92.

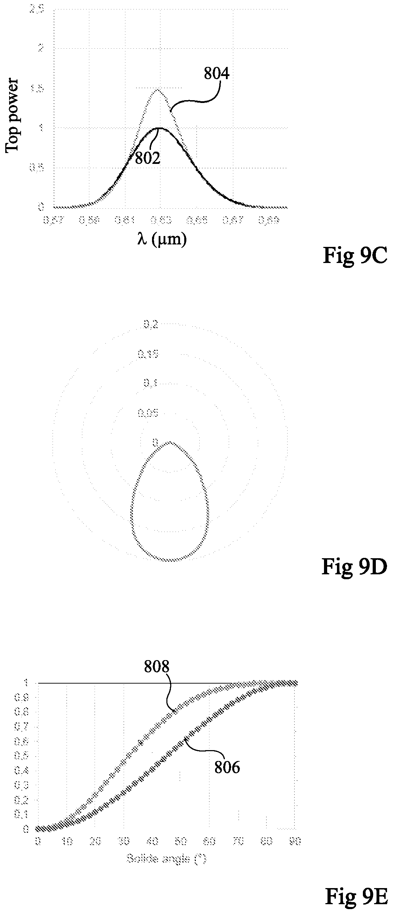

Les figures 9A à 9E sont des graphiques illustrant des résultats de simulations pour un mode de réalisation d'une matrice de diodes électroluminescentes. Plus précisément, les figures 9A et 9B illustrent des simulations dans le cas d'une matrice dont le premier quotient a/λ est dans la gamme associée à la zone 702 permettant de déterminer des caractéristiques optimales pour la matrice et les figures 9C à 9E représentent des résultats de simulations dans le cas des caractéristiques choisies.

La longueur d'onde λ des rayonnements que les diodes électroluminescentes émettent est choisie, par exemple à 450 nm pour une lumière bleue, à 530 nm pour une lumière verte ou à 630 nm pour une lumière rouge. Le choix d'une des courbes ayant un maximum dans la gamme correspondant à la zone 702 et la valeur du premier quotient a/λ au maximum de la courbe choisie permet de déterminer le rayon R des diodes électroluminescentes et le pas a de la matrice.

A titre d'exemple, on choisit ici une longueur d'onde de 630 nm et la courbe 706 dont l'extremum, dans la zone 702, correspond à la plus importante intensité émise parmi l'ensemble des courbes. Le premier quotient a/λ est alors sensiblement égal à 0,7111 et le deuxième quotient 2πR/λ est alors sensiblement égal à 1,1. Ainsi, le pas a est sensiblement égal à 448 nm et le rayon R est sensiblement égal à 110 nm.

La figure 9A illustre l'intensité émise par les faces supérieures des diodes électroluminescentes de la matrice (Top Power) en fonction de la hauteur h totale des diodes électroluminescentes dans les conditions choisies précédemment.

Il est possible d'observer trois pics d'intensité pour des hauteurs h égales à 190 nm, 375 nm et 550 nm.

Une valeur de h est choisie parmi ces valeurs. Bien que l'intensité émise par les faces supérieures soit plus importante pour la hauteur h égale à 190 nm, on choisit ici la hauteur h égale à 375 nm pour des facilités de fabrication.

La figure 9B illustre l'intensité émise par la matrice de diodes électroluminescentes ayant les caractéristiques déterminées précédemment en fonction de l'épaisseur P1 des régions 102. Il est possible d'observer, sur la plage de valeurs donnée, un unique maximum qui permet de déterminer la valeur, ici 40 nm, pour l'épaisseur P1 des régions 102.

La figure 9C illustre l'intensité du rayonnement émis par la face supérieure de la matrice en fonction de la longueur d'onde λ des rayonnements émis par les diodes électroluminescentes. La courbe 802 correspond à une matrice de diodes électroluminescentes ne formant pas un cristal photonique et la courbe 804 correspond à une matrice formant un cristal photonique et ayant les caractéristiques déterminées précédemment. Les valeurs ont été normalisées de telle manière que le maximum de la courbe 802 corresponde à la valeur 1.

On observe que la matrice de diodes électroluminescentes selon un mode de réalisation et ayant les caractéristiques déterminées précédemment émet un rayonnement dont l'intensité, au niveau de sa face supérieure, est 1,5 fois supérieure à l'intensité d'un rayonnement émis par une matrice ne formant pas de cristal photonique.

La figure 9D illustre l'intensité du rayonnement émis par la matrice décrite précédemment en fonction de l'angle entre le rayonnement émis et la direction orthogonale à la face supérieure de la matrice. Le rayonnement émis par la matrice est avantageusement directif.

La figure 9E illustre l'intensité du rayonnement émis par une matrice de manière cumulative en fonction d'un angle solide (solide angle) mesuré par rapport à la face supérieure de la matrice. La figure 9E comprend une courbe 806 correspondant à une matrice de diodes électroluminescentes axiales ne formant pas des cavités résonnantes et une courbe 808 correspondant à un cristal photonique constitué de diodes électroluminescentes axiales formant des cavités résonnantes et dont les caractéristiques sont celles déterminées précédemment.

On observe que la matrice selon un mode de réalisation (courbe 808) fournit une intensité plus directive. En effet, la matrice correspondant à la courbe 808 fournit 50 % de son intensité à un angle solide de 30° alors que la matrice correspondant à la courbe 806 fournit 50 % de son intensité à un angle solide de 45°.

Ainsi, une matrice selon le mode de réalisation de la figure 2 et dont les caractéristiques sont celles déterminées précédemment fournit un rayonnement d'intensité plus importante et plus directif que le rayonnement fourni par une matrice de diodes électroluminescentes correspondant à la courbe 806.

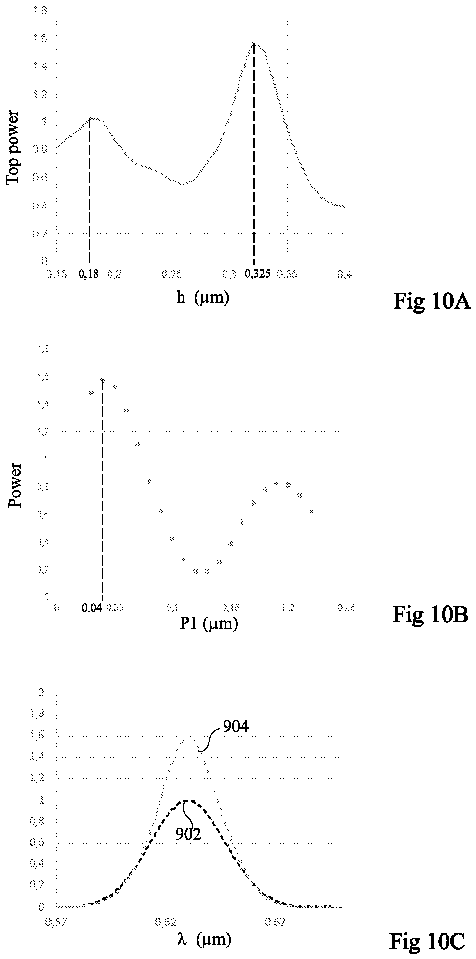

Les figures 10A à 10E sont des graphiques illustrant des résultats de simulations pour un autre mode de réalisation de matrice de diodes électroluminescentes. Plus précisément, les figures 10A et 10B illustrent des résultats de simulations dans le cas d'une matrice dont le premier quotient a/λ est dans la gamme associée à la zone 704 permettant de déterminer des caractéristiques optimales pour la matrice et les figures 10C à 10E représentent des résultats de simulations pour les caractéristiques choisies.

On choisit ici, comme précédemment, une longueur d'onde de 630 nm et on choisit, à titre d'exemple, une courbe 708 de la figure 8 dont l'extremum correspond à la plus importante intensité émise parmi les courbes proposées. Le quotient a/λ correspondant à l'extremum est sensiblement égal à 0,85 et le quotient 2πR/λ de la courbe est sensiblement égal à 1,49. Ainsi, le pas a déterminé est égal à 536,7 nm et le rayon R déterminé est égal à 150 nm.

La figure 10A illustre l'intensité émise par les faces supérieures des diodes électroluminescentes (Top Power) en fonction de la hauteur h totale des diodes électroluminescentes dans les conditions déterminées précédemment.

Il est possible d'observer deux pics d'intensité pour des hauteurs h sensiblement égales à 180 nm et 325 nm.

Une valeur de h est choisie parmi ces valeurs. On choisit ici h égale à 325 nm, qui correspond à la plus forte intensité.

La figure 10B illustre l'intensité du rayonnement émis par la matrice de diodes électroluminescentes ayant les caractéristiques déterminées précédemment en fonction de l'épaisseur P1 des régions 102.

Il est possible d'observer, sur la plage de valeurs donnée, un unique maximum qui permet de déterminer la valeur, ici 40 nm, pour l'épaisseur P1 des régions 102.

La figure 10C illustre l'intensité du rayonnement émis par la face supérieure de la matrice en fonction de la longueur d'onde λ des rayonnements émis par les diodes électroluminescentes. La courbe 902 correspond à une matrice de diodes électroluminescentes ne formant pas un cristal photonique et la courbe 904 correspond à une matrice formant un cristal photonique et ayant les caractéristiques déterminées précédemment. Les valeurs ont été normalisées de telle manière que le maximum de la courbe 902 corresponde à la valeur 1.

On observe que la matrice de diodes électroluminescentes selon un mode de réalisation et ayant les caractéristiques déterminées précédemment émet un rayonnement dont l'intensité, au niveau de sa face supérieure, est 1,6 fois supérieure à une matrice ne formant pas de cristal photonique.

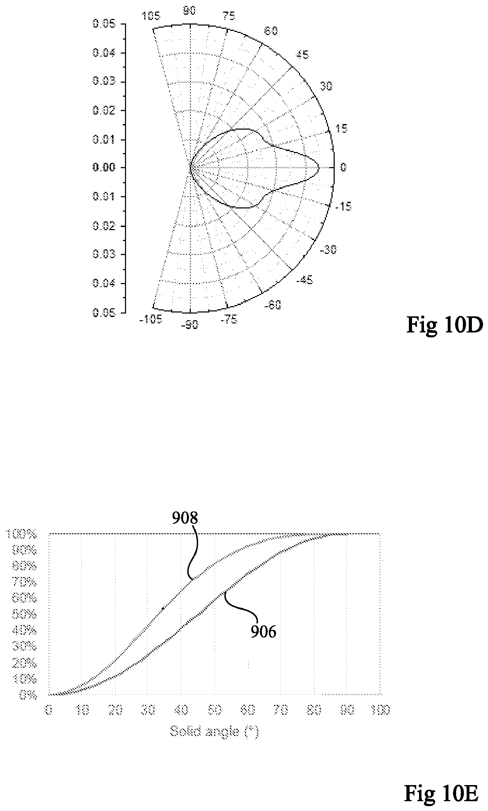

La figure 10D illustre l'intensité du rayonnement émis par la matrice décrite précédemment en fonction de l'angle entre les rayonnements émis et la direction orthogonale à la face supérieure de la matrice. On observe que le rayonnement est plus directif que dans le cas décrit en relation avec les figures 9A à 9E.

La figure 10E illustre l'intensité du rayonnement émis par une matrice de manière cumulative en fonction de l'angle solide mesuré par rapport à la face supérieure de la matrice. La figure 10E comprend une courbe 906 correspondant à une matrice comprenant des diodes électroluminescentes axiales ne formant pas des cavités résonnantes et une courbe 908 correspondant à un cristal photonique comprenant des diodes électroluminescentes axiales formant des cavités résonnantes et dont les caractéristiques sont celles déterminées précédemment.

On observe que la matrice selon un mode de réalisation (courbe 908) fournit une intensité plus directive. En effet, la matrice correspondant à la courbe 908 fournit 50 % de son intensité à un angle solide de 33° alors que la matrice correspondant à la courbe 906 fournit 50 % de son intensité à un angle solide de 45°.

Ainsi, une matrice selon le mode de réalisation de la figure 2 et dont les caractéristiques ont été déterminées comme précédemment fournit un rayonnement d'intensité plus importante et plus directif que le rayonnement fourni par une matrice de diodes électroluminescentes correspondant à la courbe 906.

Les inventeurs ont réalisé des simulations similaires pour des matrices de diodes électroluminescentes telles que décrites en relation avec les figures 1 et 2 ayant des caractéristiques différentes, notamment pour des diodes électroluminescentes ayant une section droite de forme différente, pour des diodes électroluminescentes dont les zones actives comprennent des puits quantiques multiples et non un puits quantique unique, pour des diodes électroluminescentes ayant un maillage hexagonal et non carré, ou pour des matériaux différents. Les résultats de simulation permettent alors de déterminer les valeurs des caractéristiques des diodes électroluminescentes et de la matrice, comme cela a été décrit précédemment, et montrent une augmentation de l'intensité et de la directivité du rayonnement émis par la matrice de diodes électroluminescentes.

Des modes de réalisation particuliers ont été décrits. Diverses variantes et modifications apparaîtront à l'homme de l'art. En particulier, bien que l'on ne décrive ici que le cas de diodes électroluminescentes, les modes de réalisation peuvent aussi s'appliquer à des photodiodes.

Divers modes de réalisation avec diverses variantes ont été décrits ci-dessus. On notera que l'homme de l'art pourra combiner divers éléments de ces divers modes de réalisation et variantes sans faire preuve d'activité inventive. L'invention est définie par les revendications.

## Revendications

1. Dispositif optoélectronique comprenant une matrice (200) de diodes axiales (100), chaque diode formant une cavité résonnante dans laquelle se forme une onde électromagnétique stationnaire, chaque diode électroluminescente comprenant une zone active (104) située sensiblement au niveau d'un extrémum (110) de l'onde électromagnétique, la matrice formant un cristal photonique configuré pour maximiser l'intensité du rayonnement électromagnétique fourni par la matrice de diodes, dans lequel la matrice (200) comprend un support (105, 310) sur lequel reposent les diodes (100), chaque diode comprenant un empilement d'une première région semiconductrice (102) reposant sur le support, de la zone active (104) en contact avec la première région semiconductrice et d'une deuxième région semiconductrice (106) en contact avec la zone active, le dispositif comprenant une couche réfléchissante (107, 308) entre le support (105, 310) et les premières régions (102) des diodes, les secondes régions (106) des diodes étant recouvertes d'une couche (312) conductrice et au moins en partie transparente aux rayonnements émis par les diodes.

2. Dispositif selon la revendication 1, dans lequel la couche réfléchissante (107, 308) est en métal.

3. Dispositif selon la revendication 1 ou 2, dans lequel la hauteur (h) d'au moins une des diodes (100) est sensiblement proportionnelle à kλ/2n, où λ est la longueur d'onde du rayonnement émis par la diode, k est un entier positif et n est sensiblement égal à l'indice de réfraction effectif de la diode dans le mode optique considéré.

4. Dispositif selon l'une quelconque des revendications 1 à 3, dans lequel les diodes (100) sont séparées par un matériau isolant électriquement (202, 306).

5. Dispositif selon l'une quelconque des revendications 1 à 4, la matrice comprenant au moins des premier et deuxième ensembles (604, 606, 608) de diodes, les diodes du premier ensemble ayant une même première hauteur, les diodes du deuxième ensemble ayant une même deuxième hauteur, les première et deuxième hauteurs étant différentes.

6. Dispositif selon l'une quelconque des revendications 1 à 5, dans lequel, pour au moins l'une des diodes, la première région de la diode comprend au moins deux parties (106a, 106b) séparées par une couche d'arrêt de gravure (502, 602a, 602b, 602c).

7. Dispositif selon la revendication 6, dans lequel chaque couche d'arrêt de gravure (502, 602a, 602b, 602c) a une épaisseur comprise entre 1 et 200 nm.

8. Dispositif selon l'une quelconque des revendications 1 à 7, dans lequel le quotient du pas de la matrice sur la longueur d'onde du rayonnement électromagnétique fourni est compris entre environ 0,4 et environ 0,92.

9. Dispositif selon l'une quelconque des revendications 1 à 8, dans lequel les diodes sont des diodes électroluminescentes ou des photodiodes.

10. Procédé de fabrication d'un dispositif optoélectronique comprenant une matrice (200) de diodes axiales (100), chaque diode formant une cavité résonnante dans laquelle se forme une onde électromagnétique stationnaire, la zone active (104) de chaque diode étant située sensiblement au niveau d'un extrémum (110) de l'onde électromagnétique, la matrice formant un cristal photonique configuré pour maximiser l'intensité du rayonnement électromagnétique fourni par la matrice de diodes, dans lequel la formation des diodes de la matrice comprend :
la formation de premières régions semiconductrices (106) sur un substrat (304), les premières régions étant séparées les unes des autres par le pas de la matrice ;
la formation d'au moins une couche dans la première région d'au moins l'une des diodes adaptée à servir de couche d'arrêt de gravure ;
la formation d'une zone active (104) sur chaque première région ; et
la formation d'une seconde région semiconductrice (102) sur chaque zone active.

11. Procédé selon la revendication 10, comprenant une première étape de gravure de l'ensemble des deuxièmes régions de manière à ce qu'elles aient une même hauteur.

12. Procédé selon la revendication 10 ou 11, comprenant une deuxième étape de gravure de l'ensemble des premières régions de manière à ce qu'elles aient la hauteur permettant à la zone active d'être située au niveau d'un extremum de l'onde électromagnétique.

13. Procédé selon la revendication 12, dans lequel la deuxième étape de gravure est effectuée avant la formation des zones actives.

14. Procédé selon la revendication 12, dans lequel la deuxième étape de gravure est précédée d'une étape de retrait du substrat, la deuxième étape de gravure étant réalisée par l'extrémité de la diode qui était la plus proche du substrat.

15. Procédé selon l'une quelconque des revendications 12 à 14, dans lequel la au moins une couche dans la première région d'au moins l'une des diodes est adaptée à servir de couche d'arrêt de gravure à la deuxième étape de gravure.

16. Procédé selon l'une quelconque des revendications 10 à 15, dans lequel les diodes sont des diodes électroluminescentes ou des photodiodes.

17. Procédé selon l'une quelconque des revendications 10 à 16, dans lequel la couche d'arrêt de gravure est destinée à définir la cavité résonnante.

## Patentansprüche

1. Optoelektronische Vorrichtung aufweisend ein Array (200) aus axialen Dioden (100), wobei jede Diode einen Resonanzhohlraum bildet, in dem sich eine stehende elektromagnetische Welle ausbildet, wobei jede lichtemittierende Diode eine aktive Schicht (104) aufweist, die sich im Wesentlichen auf dem Niveau eines Extremwerts (110) der elektromagnetischen Welle befindet, wobei das Array einen photonischen Kristall bildet, der konfiguriert ist zum Optimieren der Intensität der von dem Diodenarray gelieferten elektromagnetischen Strahlung, wobei das Array (200) einen Träger (105, 310) aufweist, auf dem die Dioden (100) aufliegen, wobei jede Diode einen Stapel aus einem ersten Halbleiterbereich (102), der auf dem Träger ruht, aus der aktiven Schicht (104), der mit dem ersten Halbleiterbereich in Kontakt steht, und aus einem zweiten Halbleiterbereich (106), der mit der aktiven Schicht in Kontakt steht, aufweist, wobei die Vorrichtung eine reflektierende Schicht (107, 308) zwischen dem Träger (105, 310) und den ersten Bereichen (102) der Dioden aufweist, wobei die zweiten Bereiche (106) der Dioden mit einer leitenden Schicht (312) bedeckt sind, die zumindest teilweise für die von den Dioden emittierten Strahlungen transparent ist.

2. Vorrichtung nach Anspruch 1, wobei die reflektierende Schicht (107, 308) aus Metall hergestellt ist.

3. Vorrichtung nach Anspruch 1 oder 2, wobei die Höhe (h) mindestens einer der Dioden (100) im Wesentlichen proportional zu kλ/2n ist, wobei λ die Wellenlänge der von der Diode emittierten Strahlung ist, k eine positive ganze Zahl ist und n im Wesentlichen gleich dem effektiven Brechungsindex der Diode im betrachteten optischen Modus ist.

4. Vorrichtung nach einem der Ansprüche 1 bis 3, wobei die Dioden (100) durch ein elektrisch isolierendes Material (202, 306) getrennt sind.

5. Vorrichtung nach einem der Ansprüche 1 bis 4, wobei das Array mindestens erste und eine zweite Diodenanordnungen (604, 606, 608) aufweist, wobei die Dioden der ersten Anordnung eine gleiche erste Höhe aufweisen und die Dioden der zweiten Anordnung eine gleiche zweite Höhe aufweisen, wobei die erste und die zweite Höhe unterschiedlich sind.

6. Vorrichtung nach einem der Ansprüche 1 bis 5, wobei für mindestens eine der Dioden der erste Bereich der Diode mindestens zwei Abschnitte (106a, 106b) aufweist, die durch eine Ätzstoppschicht (502, 602a, 602b, 602c) getrennt sind.

7. Vorrichtung nach Anspruch 6, wobei jede Ätzstoppschicht (502, 602a, 602b, 602c) eine Dicke im Bereich von 1 bis 200 nm aufweist.

8. Vorrichtung nach einem der Ansprüche 1 bis 7, wobei der Quotient aus dem Abstandsmaß des Arrays und der Wellenlänge der zugeführten elektromagnetischen Strahlung im Bereich von etwa 0,4 bis etwa 0,92 liegt.

9. Vorrichtung nach einem der Ansprüche 1 bis 8, wobei die Dioden lichtemittierende Dioden oder Photodioden sind.

10. Verfahren zur Herstellung einer optoelektronischen Vorrichtung, die ein Array (200) axialer Dioden (100) aufweist, wobei jede Diode einen Resonanzhohlraum bildet, in dem sich eine stehende elektromagnetische Welle ausbildet, wobei die aktive Schicht (104) jeder Diode im Wesentlichen auf dem Niveau eines Extremwerts (110) der elektromagnetischen Welle angeordnet ist, wobei das Array einen photonischen Kristall bildet, der konfiguriert ist zum Maximieren der Intensität der von dem Diodenarray gelieferten elektromagnetischen Strahlung, wobei die Ausbildung der Dioden des Arrays Folgendes aufweist
Ausbilden erster Halbleiterbereiche (106) auf einem Substrat (304), wobei die ersten Bereiche durch das Abstandsmaß des Arrays voneinander getrennt sind;
Ausbilden einer aktiven Schicht (104) auf jedem ersten Bereich; und
Ausbilden eines zweiten Halbleiterbereichs (102) auf jeder aktiven Schicht.

11. Verfahren nach Anspruch 10, das einen ersten Schritt des Ätzens aller zweiten Bereiche aufweist, so dass sie eine gleiche Höhe haben.

12. Verfahren nach Anspruch 10 oder 11, aufweisend einen zweiten Schritt des Ätzens aller ersten Bereiche, so dass sie die Höhe haben, die es ermöglicht, dass sich die aktive Schicht auf dem Niveau eines Extremwerts der elektromagnetischen Welle befindet.

13. Verfahren nach Anspruch 12, wobei der zweite Ätzschritt vor der Bildung der aktiven Schichten durchgeführt wird.

14. Verfahren nach Anspruch 12, wobei dem zweiten Ätzschritt ein Schritt des Entfernens des Substrats vorausgeht, wobei der zweite Ätzschritt von dem Ende der Diode aus durchgeführt wird, das dem Substrat am nächsten war.

15. Verfahren nach einem der Ansprüche 12 bis 14, aufweisend das Ausbilden mindestens einer Schicht in dem ersten Bereich mindestens einer der Dioden, die als Stoppschicht für den zweiten Ätzschritts verwendet werden kann.

16. Verfahren nach einem der Ansprüche 10 bis 15, wobei die Dioden lichtemittierende Dioden oder Photodioden sind.

17. Verfahren nach einem der Ansprüche 10 bis 16, wobei die Stoppschicht dazu bestimmt ist, den Resonanzhohlraum zu definieren.

## Claims

1. An optoelectronic device comprising an array (200) of axial diodes (100), each diode forming a resonant cavity having a standing electromagnetic wave forming therein, each light-emitting diode comprising an active area (104) located substantially at the level of an extremum (110) of the electromagnetic wave, the array forming a photonic crystal configured to maximize the intensity of the electromagnetic radiation supplied by the diode array, wherein the array (200) comprises a support (105, 310) having the diodes (100) resting thereon, each diode comprising a stack of a first semiconductor region (102) resting on the support, of the active area (104) in contact with the first semiconductor region, and of a second semiconductor region (106) in contact with the active area, the device comprising a reflective layer (107, 308) between the support (105, 310) and the first regions (102) of the diodes, the second regions (106) of the diodes being covered with a conductive layer (312) at least partly transparent to the radiations emitted by the diodes.

2. The device of claim 1, wherein the reflective layer (107, 308) is made of metal.

3. The device of claim 1 or 2, wherein the height (h) of at least one of the diodes (100) is substantially proportional to kλ/2n, where λ is the wavelength of the radiation emitted by the diode, k is a positive integer, and n is substantially equal to the effective refraction index of the diode in the considered optical mode.

4. The device of any of claims 1 to 3, wherein the diodes (100) are separated by an electrically-insulating material (202, 306).

5. The device of any of claims 1 to 4, the array comprising at least first and second diode assemblies (604, 606, 608), the diodes of the first assembly having a same first height, the diodes of the second assembly having a same second height, the first and second heights being different.

6. The device of any of claims 1 to 5, wherein, for at least one of the diodes, the first region of the diode comprises at least two portions (106a, 106b) separated by an etch stop layer (502, 602a, 602b, 602c).

7. The device of claim 6, wherein each etch stop layer (502, 602a, 602b, 602c) has a thickness in the range from 1 to 200 nm.

8. The device of any of claims 1 to 7, wherein the quotient of the pitch of the array to the wavelength of the supplied electromagnetic radiation is in the range from approximately 0.4 to approximately 0.92.

9. The device of any of claims 1 to 8, wherein the diodes are light-emitting diodes or photodiodes.

10. A method of manufacturing an optoelectronic device comprising an array (200) of axial diodes (100), each diode forming a resonant cavity having a standing electromagnetic wave forming therein, the active area (104) of each diode being located substantially at the level of an extremum (110) of the electromagnetic wave, the array forming a photonic crystal configured to maximize the intensity of the electromagnetic radiation supplied by the diode array, wherein the forming of the diodes of the array comprises:
forming first semiconductor regions (106) on a substrate (304), the first regions being separated from one another by the pitch of the array;
forming an active area (104) on each first region; and
forming a second semiconductor region (102) on each active area.

11. The method of claim 10, comprising a first step of etching all the second regions so that they have a same height.

12. The method of claim 10 or 11, comprising a second step of etching all the first regions so that they have the height enabling the active area to be located at the level of an extremum of the electromagnetic wave.

13. The method of claim 12, wherein the second etch step is carried out before the forming of the active areas.

14. The method of claim 12, wherein the second etch step is preceded by a step of removing the substrate, the second etch step being carried out from the end of the diode which was closest to the substrate.

15. The method of any of claims 12 to 14, comprising forming at least one layer in the first region of at least one of the diodes capable of being used as a stop layer of the second etch step.

16. The method of any of claims 10 to 15, wherein the diodes are light-emitting diodes or photodiodes.

17. The method of any of claims 10 to 16, wherein the stop layer is destined to define the resonant cavity.
